# FASCICULE DE BREVET EUROPEEN

(11) **EP 3 925 930 B1**
(45) Date de publication et mention de la délivrance du brevet: **15.03.2023**
(21) Numéro de dépôt: 21179985.3
(22) Date de dépôt: 17.06.2021
(51) Int. Cl.: B81C 1/00

(54) **PROCÉDÉ DE FABRICATION D'UN DISPOSITIF MICROÉLECTRONIQUE COMPRENANT UNE MEMBRANE SUSPENDUE AU-DESSUS D'UNE CAVITÉ**
VERFAHREN ZUR HERSTELLUNG EINER MIKROELEKTRONISCHEN VORRICHTUNG MIT EINER MEMBRAN, DIE ÜBER EINEN HOHLRAUM GESPANNT IST
METHOD FOR MANUFACTURING A MICROELECTRONIC DEVICE COMPRISING A MEMBRANE SUSPENDED OVER A CAVITY

(30) Priorité: 18.06.2020 FR 2006397
(43) Date de publication de la demande: 22.12.2021
(73) Titulaire: Commissariat à l'Energie Atomique et aux Energies Alternatives, 75015 Paris (FR)
(72) Inventeur: CARTIER, Mathilde, 38054 GRENOBLE Cedex 09 (FR); FAIN, Bruno, 38054 GRENOBLE Cedex 09 (FR)
(74) Mandataire: Hautier IP

(56) Documents cités:
- WO-A1-2014/206737
- CHANG-HAN YUN ET AL: "Fabrication of Silicon and Oxide Membranes Over Cavities Using Ion-Cut Layer Transfer", JOURNAL OF MICROELECTROMECHANICAL SYSTEMS, IEEE SERVICE CENTER, US, vol. 9, no. 4, 1 décembre 2000 (2000-12-01), XP011034603, ISSN: 1057-7157

## Description

### DOMAINE TECHNIQUE

La présente invention concerne le domaine des dispositifs micro-électroniques comprenant une membrane suspendue au-dessus d'une cavité. Elle trouve pour application particulièrement avantageuse le domaine des transducteurs connus sous le nom « *Micromachined Ultrasonic Transducer* », abrégé MUT, que l'on peut traduire par transducteur ultrasonore micro-usiné.

### ETAT DE LA TECHNIQUE

Le développement des MEMS et NEMS a généralisé les débouchés de la microélectronique vers de nombreuses applications, notamment pour des applications reposant sur des dispositifs membranaires.

Ces dispositifs sont par exemple des transducteurs acoustiques. Les transducteurs peuvent employer diverses techniques d'activation de la membrane ou de mesure de l'activité de la membrane. L'une d'entre-elles utilise la piézoélectricité. Un tel transducteur, connu sous le nom « *Piezoelectric Micromachined Ultrasonic Transducer* » ou sous son acronyme pMUT, génère et/ou détecte une onde ultrasonore au moyen d'une membrane mise en mouvement par un actionneur piézoélectrique déposé en couche mince sur cette dernière pour la génération de l'onde et par la génération de charges électriques dans la couche piézoélectrique lors de la détection.

D'autres transducteurs obéissent à un contrôle capacitif. Un tel transducteur, connu sous le nom « *Capacitive Micromachined Ultrasonic Transducer* » ou sous son acronyme cMUT, génère et/ou détecte quant à lui une onde ultrasonore au moyen d'une membrane mise en mouvement par effet capacitif entre la membrane et le fond de la cavité du cMUT.

Ces dispositifs MEMS comprennent une ou une pluralité de membranes, formant la partie mécanique vibratoire du dispositif. Elle est typiquement suspendue au-dessus d'une cavité. Elle produit ainsi une structure déformable essentiellement en flexion. Lors du fonctionnement du dispositif en réception, la flexion de la membrane peut être convertie en un signal électrique, et inversement pour un fonctionnement en émission. Le bon fonctionnement de ces dispositifs dépend notamment de l'état de la membrane. La fabrication de ces membranes est en soi une difficulté technique au regard de l'échelle de dimension concernée, étant rappelé que l'épaisseur de la membrane est souvent bien inférieure à 10 µm (10⁻⁶ m) et généralement de moins de 1 µm. Une difficulté est de préserver la fiabilité mécanique de la suspension de la membrane durant les étapes de fabrication du dispositif. En outre, selon le type de dispositif, la géométrie de la cavité peut varier.

Il existe des procédés de fabrication d'un dispositif microélectronique comprenant une membrane suspendue au-dessus d'une cavité dans lesquels un substrat support comprenant des cavités débouchant en surface de ce substrat, et un substrat donneur, sont fournis. Le substrat support et le substrat donneur sont ensuite assemblés en adjoignant la surface du substrat support à la surface du substrat donneur. Ensuite, le substrat donneur est aminci de façon à former la membrane, qui est alors suspendue au-dessus des cavités formées dans le substrat support. En pratique, ces procédés s'avèrent limités quant aux géométries de cavités pouvant être obtenues. Notamment, il reste difficile d'obtenir une membrane de faible épaisseur suspendue sur des cavités de grandes dimensions.

Le document CHANG-HAN YUN ET AL: "Fabrication of Silicon and Oxide Membranes Over Cavities Using lon-Cut Layer Transfer",JOURNAL OF MICROELECTROMECHANICAL SYSTEMS, IEEE SERVICE CENTER, US, vol. 9, no. 4, 1 décembre 2000 (2000-12-01), ISSN: 1057-7157 décrit un procédé de fabrication d'un dispositif microélectronique comprenant une membrane suspendue au-dessus d'au moins une cavité finale, le procédé comprenant la fourniture d'un substrat support comprenant une couche superficielle, la formation d'au moins une cavité élémentaire dans la couche superficielle du substrat support, la fourniture d'un substrat donneur, puis la formation d'au moins une membrane suspendue au-dessus d'au moins une cavité finale, la formation de la membrane comprenant un assemblage du substrat support et du substrat donneur de sorte que le substrat donneur recouvre au moins en partie la cavité élémentaire, puis un amincissement du substrat donneur de façon à former la membrane.

Un objet de la présente invention est donc de proposer un procédé de fabrication d'un dispositif comprenant une membrane suspendue au-dessus d'une cavité d'un substrat, permettant de pallier aux inconvénients précités. Notamment, un objectif de l'invention peut être de proposer un procédé de fabrication d'un dispositif comprenant une membrane suspendue au-dessus d'une cavité d'un substrat, permettant de moduler les dimensions de la cavité tout en préservant l'intégrité de la membrane.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un procédé de fabrication d'un dispositif microélectronique comprenant une membrane suspendue au-dessus d'au moins une cavité finale, le procédé comprenant :
- une fourniture d'un substrat support comprenant une couche superficielle présentant une première face,
- une formation d'au moins une cavité élémentaire dans la couche superficielle du substrat support, l'au moins une cavité élémentaire débouchant au niveau de ladite première face, et
- une fourniture d'un substrat donneur présentant une première face, puis
- une formation d'au moins une membrane suspendue au-dessus d'au moins une cavité finale, la formation de la membrane comprenant :
   ∘un assemblage du substrat support et du substrat donneur en adjoignant la première face du substrat support à la première face du substrat donneur, de sorte que le substrat donneur recouvre au moins en partie l'au moins une cavité élémentaire, puis
   ∘un amincissement du substrat donneur de façon à former la membrane.

Avantageusement, avant ou après la formation de la membrane, le procédé comprend en outre une formation d'au moins un pilier d'ancrage de la membrane, l'au moins un pilier d'ancrage étant :
- fait ou à base d'au moins un matériau différent d'un matériau formant la couche superficielle, et
- configuré pour supporter au moins une face inférieure de la membrane, au moins au niveau d'une bordure de la membrane.

Après la formation de l'au moins un pilier d'ancrage, et après l'assemblage, le procédé comprend avantageusement une gravure de la couche superficielle du substrat support de façon à élargir l'au moins une cavité élémentaire, selon au moins une direction parallèle à un plan principal d'extension de la première face de la couche superficielle du substrat support, pour former la cavité finale.

Ladite gravure est configurée de façon à graver sélectivement la couche superficielle vis-à-vis de l'au moins un matériau de l'au moins un pilier d'ancrage.

Ainsi, la gravure de la couche superficielle du substrat support permet d'élargir l'au moins une cavité élémentaire après que la membrane a été transférée du substrat donneur sur le substrat support. Le risque que la membrane soit endommagée durant le procédé est limité, voire évité. Par conséquent, il est possible d'obtenir une membrane suspendue au-dessus d'au moins une cavité finale plus étendue que grâce aux solutions existantes.

En formant un pilier d'ancrage plus résistant à la gravure que la couche superficielle, la gravure peut se propager dans la couche superficielle du substrat support jusqu'à atteindre le pilier d'ancrage, qui sera conserver. Selon les modes de réalisation envisagés, le pilier d'ancrage peut former ainsi une limite physique à la gravure de la couche superficielle du substrat support.

En pratique, la gravure de la couche superficielle du substrat support peut s'avérer difficile à contrôler pour obtenir des cavités finales de forme définies et reproductibles. L'utilisation de pilier d'ancrage comme limite physique à la gravure permet l'obtention de cavités finales mieux définies, et ce, avec une meilleure reproductibilité.

En outre, l'utilisation de pilier d'ancrage comme limite physique à la gravure permet, selon la disposition du ou des pilier(s) d'ancrage, de personnaliser les dimensions et/ou la forme d'une ou des cavités finales. Notamment, la ou les cavités finales obtenues ne dépendent pas nécessairement de la géométrie des cavités élémentaires.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente une vue en coupe transversale de la portion supérieure d'un substrat support mis en oeuvre dans le procédé, selon un exemple de réalisation.
Les figures 2 à 3B représentent, à partir du substrat illustré en figure 1, la formation d'au moins une cavité élémentaire dans le substrat support, selon des vues en coupe transversale et une vue du dessus.
La figure 4 représente une vue en coupe transversale de la couche superficielle d'un substrat donneur mis en oeuvre dans le procédé selon un exemple de réalisation.
La figure 5 représente l'assemblage du substrat support illustré en figure 3A et du substrat donneur illustré en figure 4, selon une vue en coupe transversale.
Les figures 6A et 6B représentent, à partir de l'assemblage illustré en figure 5, l'amincissement du substrat donneur pour former la membrane, selon une vue en coupe transversale, pour un exemple de réalisation du procédé.
Les figures 7A à 7D représentent, à partir de l'assemblage illustré en figure 5, l'amincissement du substrat donneur pour former la membrane, selon une vue en coupe transversale, pour un autre exemple de réalisation du procédé.
Les figures 8A à 8C représentent, suite à la formation de la membrane, une gravure du substrat donneur pour différents exemples de réalisation du procédé, selon une vue en coupe transversale.
Les figures 9A et 9B représentent la formation d'un pilier d'ancrage à partir de l'assemblage illustré en figure 8A, pour un exemple de réalisation du procédé, et selon une vue en coupe transversale selon le plan B-B illustré en figure 9C, et une vue du dessus.
La figure 9C représente une vue en coupe selon le plan C-C illustré en figure 9A.
Les figures 9D et 9E représentent la formation d'un pilier d'ancrage à partir de l'assemblage illustré respectivement en figure 8B et 8C, pour un exemple de réalisation du procédé, et selon une vue en coupe transversale.
Les figures 10A et 10B représentent une formation d'ouverture dans la membrane à partir de l'assemblage illustré en figure 9A, pour un exemple de réalisation du procédé et selon une vue en coupe transversale selon le plan D-D illustré en figure 10B, et une vue du dessus.
Les figures 11A et 11B représentent le dispositif après gravure de la couche superficielle du substrat support, à partir de l'assemblage illustré en figure 10A, pour un exemple de réalisation du procédé et selon une vue en coupe transversale selon le plan E-E illustré en figure 11C, et une vue du dessus.
La figure 11C représente une vue en coupe selon le plan F-F illustré en figure 11A.
La figure 12A représente une vue du dessus du dispositif après gravure de la couche superficielle du substrat support, pour un autre exemple de réalisation du procédé et selon une vue du dessus.
La figure 12B représente une vue en coupe du dispositif illustré en figure 12A, selon un plan de coupe équivalent au plan F-F illustré en figure 11A.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs et les dimensions relatives de substrat, de couche, ou des portions, illustrés ne sont pas représentatifs de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
- le matériau de l'au moins un pilier d'ancrage présente une résistance à une gravure de la couche superficielle du substrat support, supérieure à une résistance de la couche superficielle à ladite gravure,
- le matériau de la membrane présente également une résistance à une gravure de la couche superficielle du substrat support, supérieure à une résistance de la couche superficielle à ladite gravure,
- la gravure de la couche superficielle du substrat support est réalisée après l'amincissement,
- l'élargissement de l'au moins une cavité élémentaire comprend la fusion de l'au moins une cavité élémentaire avec au moins une cavité élémentaire voisine, voire adjacente,
- la formation de l'au moins un pilier d'ancrage est effectuée avant l'assemblage du substrat support et du substrat donneur,
- la formation de l'au moins un pilier d'ancrage est effectuée après l'assemblage du substrat support et du substrat donneur,
- la formation de l'au moins un pilier d'ancrage est configurée de sorte que l'au moins un pilier d'ancrage est continu, et s'étend le long d'au moins une bordure de la membrane. Selon un exemple, le pilier s'ancrage est continu et s'étend le long d'au moins une bordure de la membrane en formant un pourtour fermé,
- la formation de l'au moins un pilier d'ancrage est configurée de sorte que l'au moins un pilier d'ancrage est ponctuel, une pluralité de piliers d'ancrage étant repartis le long d'au moins une bordure de la membrane. Selon un exemple, le pilier d'ancrage est ponctuel, une pluralité de piliers d'ancrage étant repartis régulièrement le long d'au moins une bordure de la membrane,
- la formation de l'au moins un pilier d'ancrage est configurée de sorte que l'au moins un pilier d'ancrage est configuré pour enserrer au moins la face inférieure et une face supérieure de la membrane,
- l'au moins une cavité élémentaire est définie par des parois latérales et un fond,
- la formation de l'au moins un pilier d'ancrage est effectuée après l'assemblage du substrat support et du substrat donneur et comprend :
   ∘une gravure d'au moins une portion de l'assemblage formé par le substrat donneur et le substrat support, depuis l'un parmi une deuxième face du substrat donneur ou une face supérieure de la membrane, jusqu'à une profondeur du substrat support égale à une profondeur du fond de l'au moins une cavité élémentaire,
   a un dépôt de l'au moins un matériau de l'au moins un pilier d'ancrage,
- le dépôt de l'au moins un matériau de l'au moins un pilier d'ancrage, est un dépôt par couches atomiques, communément désigné en anglais par « *Atomic Layer Deposition »*, abrégé ALD,
- la gravure de la couche superficielle du substrat support comprend :
   ∘une formation d'au moins une ouverture à travers l'un parmi le substrat donneur et la membrane,
   a une injection par l'au moins une ouverture, d'un composé de gravure,
- l'au moins une ouverture est formée à l'aplomb d'au moins une cavité élémentaire,
- une ouverture est formée à l'aplomb de chaque cavité élémentaire,
- en projection dans un plan parallèle au plan principal d'extension de la couche superficielle du substrat support, la surface d'une ouverture est contenue dans la surface d'une cavité élémentaire,
- lors de la formation de l'au moins une cavité élémentaire dans la couche superficielle du substrat support, plusieurs cavités élémentaires sont formées,
- les cavités élémentaires forment un réseau, de préférence périodique dans le plan principal d'extension de la première face de la couche superficielle du substrat support,
- le procédé comprend, préalablement à la gravure de la couche superficielle du substrat support, une étape de définition d'un groupe de cavités élémentaires, et la gravure de la couche superficielle du substrat support est configurée pour fusionner ensemble les cavités élémentaires dudit groupe, pour former la cavité finale,
- les cavités élémentaires étant chacune définies par des parois latérales et un fond, les cavités élémentaires du groupe sont séparées deux à deux par une paroi latérale commune. La cavité finale peut être formée par la gravure des parois latérales communes du groupe de cavités élémentaires,
- l'amincissement du substrat donneur comprend une oxydation du substrat donneur, pour former une portion oxydée s'étendant jusqu'à une première portion du substrat donneur destinée à former la membrane, puis une gravure de la portion oxydée du substrat donneur,
- la fourniture du substrat donneur comprend une implantation d'ions dans une portion enterrée du substrat donneur, la portion enterrée étant disposée à l'interface entre une première portion du substrat donneur destinée à former la membrane et une deuxième portion du substrat donneur destinée à former le reste du substrat donneur, et l'amincissement du substrat donneur comprend une fracture du substrat donneur au niveau de la portion enterrée,
- l'amincissement du substrat donneur comprend au moins une rectification mécanique et/ou au moins un polissage mécano-chimique et/ou au moins une gravure chimique et/ou au moins une gravure plasma, au niveau de sa face arrière, par exemple après la fracture,
- l'assemblage du substrat support et du substrat donneur comprend le collage direct de la première face du substrat donneur à la première face du substrat support,
- l'amincissement du substrat donneur est configuré de façon à obtenir une membrane d'épaisseur comprise entre 0,05 µm et 20 µm, de préférence entre 0,1 et 2 µm,
- l'au moins un pilier d'ancrage est fait ou est à base d'au moins un parmi le silicium monocristallin, le silicium poly-cristallin, le nitrure de silicium, l'alumine, et un polymère, tel que le parylène,
- au moins l'une parmi une portion supérieure du substrat support et une couche superficielle du substrat donneur est faite ou est à base d'au moins un parmi le silicium, un alliage semi-conducteur de silicium tels que le carbure de silicium et un alliage de silicium-germanium. De préférence, au moins l'une parmi une portion supérieure du substrat support et une couche superficielle du substrat donneur est faite ou est à base de silicium monocristallin. Selon un exemple, la portion supérieure sous-jacente à la couche superficielle est en silicium et la couche superficielle est en oxyde de silicium.

Il est précisé que dans le cadre de la présente invention, le terme « sur », « surmonte », ou leurs équivalents ne signifient pas forcément « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément. Une couche peut par ailleurs être composée de plusieurs sous-couches d'un même matériau ou de matériaux différents.

Dans la description qui suit, les épaisseurs de couche, de zone ou de portion ainsi que les profondeurs sont généralement mesurées selon une direction verticale, parallèle à la direction d'empilement et perpendiculaire au plan principal d'extension du substrat, de la couche, de la sous-couche ou de la portion.

On entend par un substrat, une couche, une zone ou une portion « à base » d'un matériau A, un substrat, une couche, une zone ou une portion comprenant ce matériau A, par exemple à hauteur d'au moins 50%, et éventuellement d'autres matériaux, par exemple des éléments dopants.

Dans la suite, on utilise un repère dont la direction longitudinale ou avant/arrière correspond à l'axe x, la direction transversale ou gauche/droite correspond à l'axe y, et la direction verticale ou bas/haut correspond à l'axe z.

On entend par un paramètre « sensiblement égal/supérieur/inférieur à » une valeur donnée, que ce paramètre est égal/supérieur/inférieur à la valeur donnée, à plus ou moins 10 % près, voire à plus ou moins 5 % près, de cette valeur.

On entend par « collage direct » un collage sans apport de matière adhésive (de type colle ou polymère notamment) qui consiste en la mise en contact de surfaces relativement lisses (d'une rugosité typiquement inférieure à 5 Å, 1 Å étant égal à 10⁻¹⁰ m), par exemple réalisé à température ambiante et sous atmosphère ambiante, afin de créer une adhérence entre elles. Selon un exemple, le collage direct de deux substrats signifie que le collage est obtenu par adhésion moléculaire, c'est à dire par les liens chimiques qui s'établissent entre les deux surfaces mises en contact.

Par dispositif microélectronique, on entend tout type de dispositif réalisé avec les moyens de la microélectronique. Ces dispositifs englobent notamment, en plus des dispositifs à finalité purement électronique, des dispositifs micromécaniques ou électromécaniques (MEMS, de l'anglais *microelectromechanical systems* que l'on peut traduire par systèmes microélectromécaniques, NEMS, de l'anglais *nanoelectromechanical systems* que l'on peut traduire par systèmes nanoélectromécaniques,...) ainsi que des dispositifs optiques ou optoélectroniques (MOEMS, de l'anglais Micro-Opto-Electro-Mechanical System que l'on peut traduire par microsystèmes opto-électro-mécaniques,...).

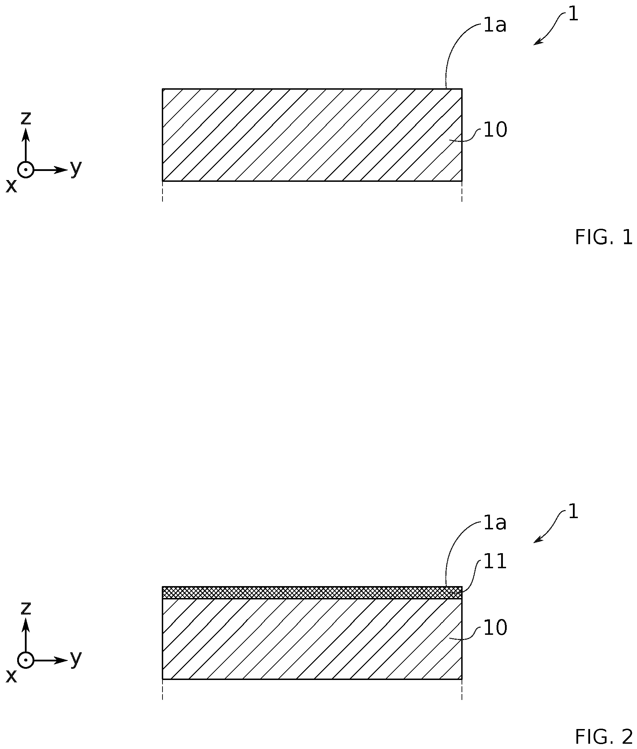

Le procédé de fabrication d'un dispositif microélectronique, comprenant une membrane 20' suspendue au-dessus d'au moins une cavité finale 110', est maintenant décrit selon un exemple de réalisation et en référence aux figures 1 à 12B. Notons que, dans le cadre de la présente demande, le terme « membrane » n'implique pas de caractéristique limitative particulière. Le terme « membrane » désigne de façon équivalente un film ou une couche, d'épaisseur quelconque. Par « suspendue » au-dessus d'au moins une cavité, on entend que la membrane surplombe l'au moins une cavité, en la recouvrant au moins partiellement, voire totalement. Comme nous le verrons en détail ultérieurement, la membrane peut être suspendue par au moins un point d'ancrage, aussi appelé pilier d'ancrage.

Comme détaillé dans la suite, le procédé comprend plusieurs étapes de gravures. Chacune des gravures peut être une gravure sèche, et de préférence humide. Chacune des étapes de gravures peut être précédée par l'application d'un masquage, par exemple issu d'une lithographie positive ou négative, et suivie par le retrait de ce masquage. Ce masquage peut être une résine, par exemple une résine photosensible. Comme illustré en figure 1, le procédé comprend la fourniture d'un substrat support 1. Le substrat support 1 comprend une portion supérieure 10, par exemple faite ou à base de matériau semi-conducteur monocristallin. À titre d'exemple, le matériau semi-conducteur peut être choisi parmi le silicium, ou des alliages de silicium semiconducteurs tels que le carbure de silicium de formule SiC et un alliage de silicium-germanium de formule Si-Ge. Dans la suite, on se réfère au cas où le matériau semi-conducteur est fait à base de silicium.

Notons que sur les figures, seule la portion supérieure 10 du substrat support 1 est représentée. Le substrat support 1 peut néanmoins être sous la forme d'un empilement d'une pluralité de couches, par exemple faites ou à base de différents matériaux. La portion supérieure 10 peut en outre être uniquement constituée de silicium monocristallin, en négligeant les impuretés liées à la l'élaboration du silicium. Le substrat support 1 peut par exemple être une plaquette, communément appelée *wafer*, de silicium. Selon un exemple, le substrat support 1 est un wafer de silicium de diamètre 200 mm (10⁻³ m).

Comme illustré en figure 2, le substrat support 1 comprend une couche superficielle 11, située en surface du substrat support 1 et présentant une première surface 1a. La couche superficielle 11 peut plus particulièrement surmonter la portion supérieure 10. La couche superficielle 11 est plus particulièrement à base de ou faite d'un matériau différent du matériau formant la portion supérieure 10. De préférence, la couche superficielle 11 est à base de ou est faite d'un oxyde. Selon un exemple, la couche superficielle 11 est un oxyde du matériau de la portion supérieure 10.

Le procédé comprend ensuite la formation d'au moins une cavité élémentaire 110 dans la couche superficielle 11 du substrat support 1. Dans la suite, on se réfère à l'exemple selon lequel plusieurs cavités élémentaires sont formées dans la couche superficielle 11. Les cavités élémentaires 110 débouchent au niveau de la première face 1a du substrat support 1. Comme l'illustre le passage de la figure 1 à la figure 2, la formation des cavités élémentaires 110 peut comprendre une oxydation d'une portion de la portion supérieure 10 pour former la couche superficielle 11 au niveau au moins de la première face 1a du substrat support 1. Cette oxydation peut être une oxydation thermique. La couche superficielle 11 peut s'étendre selon un plan parallèle au plan principal d'extension (x, y) de la portion supérieure 10. L'épaisseur de la couche superficielle 11 peut être de quelques centaines de nm (10⁻⁹ m), par exemple cette épaisseur est comprise entre 100 nm et 3 µm.

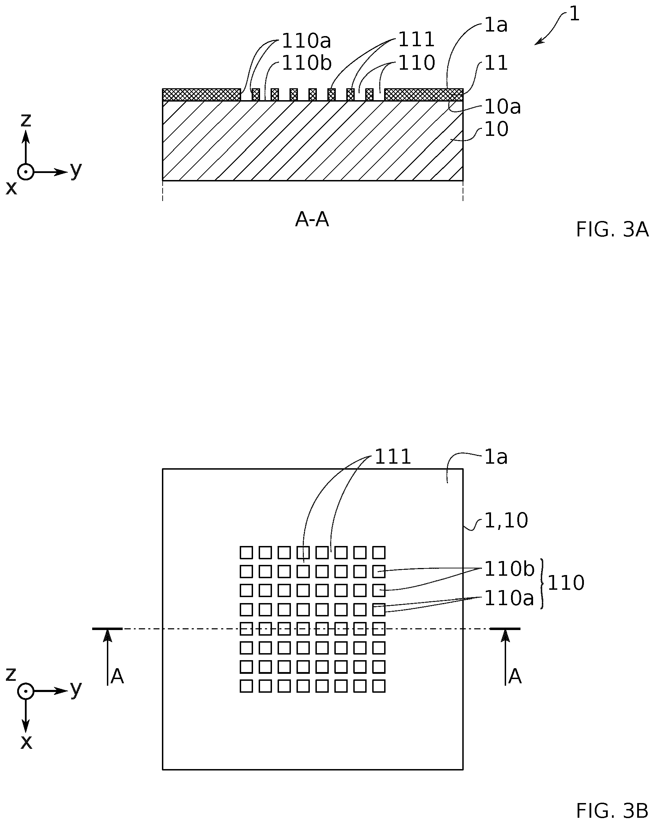

Les cavités élémentaires110 peuvent être gravées dans la couche superficielle 11, comme illustré en figure 3A. Les cavités élémentaires 110 peuvent être délimitées par des parois latérales 110a et un fond 110b parallèle au plan principal d'extension (x, y) de la couche superficielle 11, voire confondu avec une surface 10a à l'interface entre la couche superficielle 11 et la portion supérieure 10. Les cavités élémentaires 110 peuvent s'étendre verticalement sur sensiblement toute l'épaisseur de la couche superficielle 11.

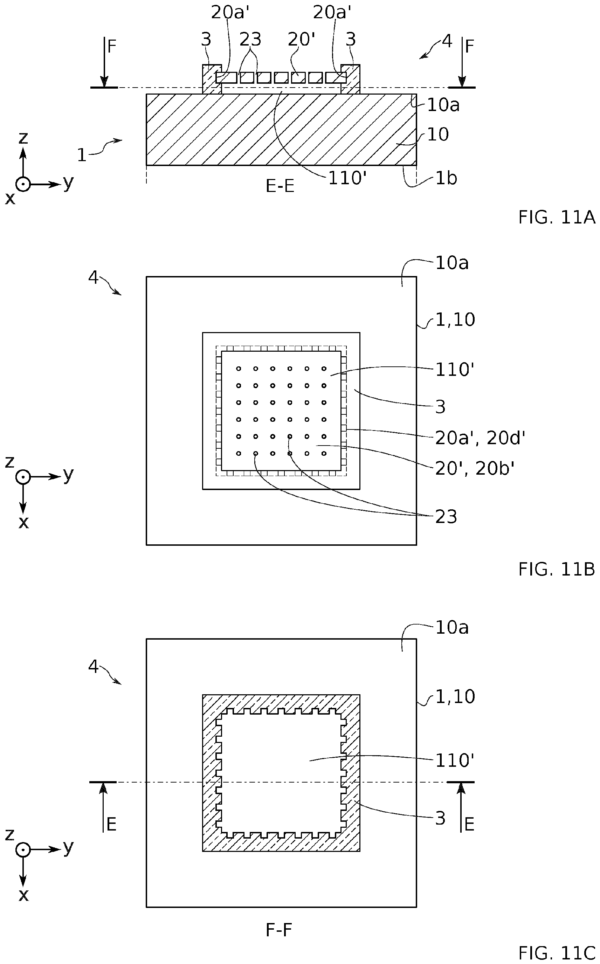

Les cavités élémentaires 110 peuvent être de formes et de dimensions variées selon le dispositif 4 visé, illustré dans les figures 11A à 12B décrites ultérieurement. Elles peuvent être par exemple carrées, rectangulaires, rondes ou polygonales. Leurs dimensions latérales, dans le plan (x, y), peuvent être comprises entre sensiblement 1 µm (10⁻⁶ m) et plusieurs centaines de µm, de préférence entre 1 µm et quelques dizaines de µm. La profondeur des cavités élémentaires 110 peut être comprises entre quelques dizaines de nm et quelques µm, de préférence entre quelques dizaines de nm et quelques centaines de nm, selon l'axe z illustré en figure 3A. Notamment, la profondeur des cavités élémentaires 110 peut être inférieure ou de préférence égale à l'épaisseur de la couche superficielle 11.

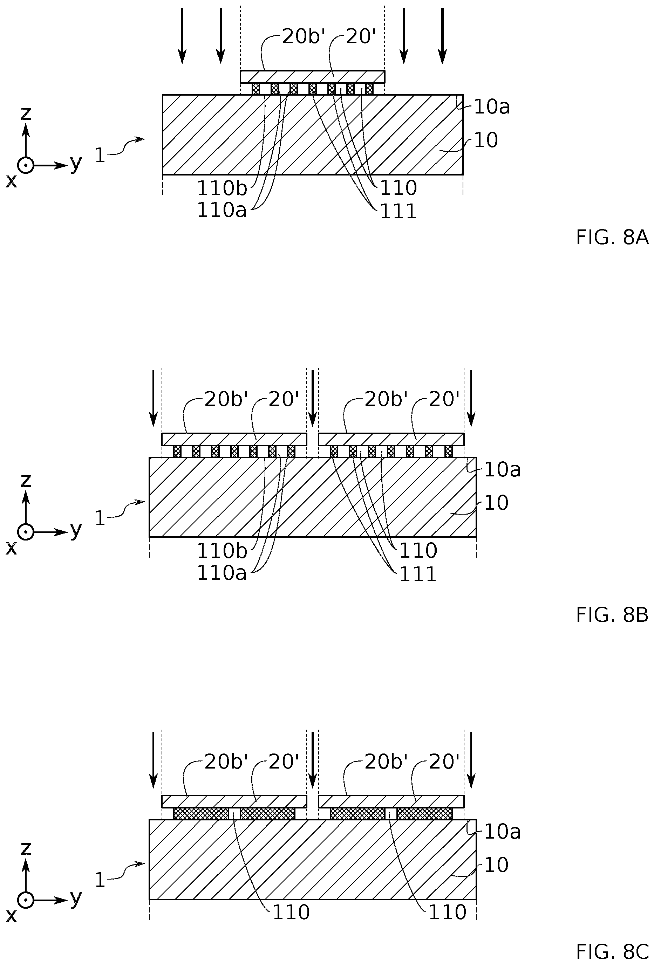

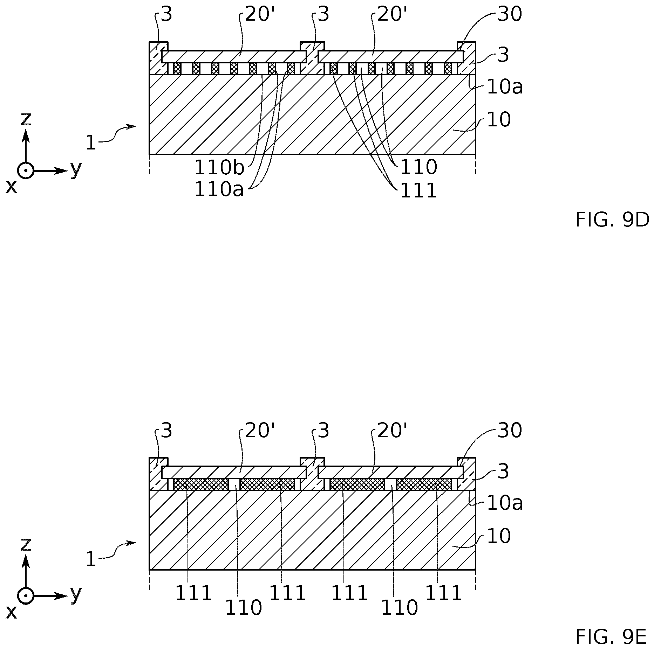

Les cavités élémentaires 110 peuvent être espacées entre elles par des portions 111 de la couche superficielle 11. Ces portions 111 peuvent être de dimensions latérales, dans le plan (x, y), supérieures aux dimensions latérales des cavités élémentaires 110, par exemple au moins trois fois supérieures. Ces cavités élémentaires 110 peuvent être illustrées par exemple par les figures 8C et 9D. Selon un exemple alternatif, les cavités élémentaires 110 peuvent être espacées entre elles par des portions 111 de la couche superficielle 11, de dimensions latérales, du même ordre de grandeur que les dimensions latérales des cavités élémentaires. Les portions 111 séparant les cavités élémentaires sont désignées par le terme « pilier ». Chaque pilier 111 peut présenter des dimensions latérales, dans le plan (x, y), comprises entre quelques µm à quelques centaines de µm, voire à quelques mm. On verra dans la suite qu'au moins une partie de ces piliers 111 peuvent être qualifiés de « temporaires ».

Les cavités élémentaires 110 peuvent former un réseau périodique dans le plan principal d'extension (x, y) de la couche superficielle 11, comme l'illustre par exemple la figure 3B. La répartition planaire des cavités élémentaires110, c'est-à-dire leur répartition dans le plan (x,y) dépend également du dispositif visé et définit la dimension des piliers 111. Les cavités élémentaires 110 peuvent être sensiblement identiques entre elles et réparties de façon uniforme dans la couche superficielle 11 du substrat support 1.Notons que le substrat support 1 peut présenter des cavités élémentaires 110 présentant des formes, des dimensions latérales, des profondeurs et/ou une répartition planaire différentes, selon les zones de la couche superficielle 11, en particulier s'il est prévu de co-intégrer des dispositifs 4 de différents types sur le substrat support 1.

Les cavités élémentaires 110 peuvent être formées au préalable par un fournisseur du substrat support 1. Typiquement, le substrat support 1 fourni présente alors des cavités élémentaires de dimensions latérales de quelques dizaines de µm, par exemple entre 10 µm et 20 µm. Dans le cas d'un substrat générique, les cavités élémentaires 110 sont typiquement sensiblement identiques entre elles et réparties de façon uniforme dans la couche superficielle 11. Comme on le verra par la suite, le procédé permet en effet, à partir de cavités élémentaires 110, par exemple issues d'un substrat disponible chez un fournisseur, d'obtenir une ou des cavités finales 110' de dimensions et/ou de forme personnalisées.

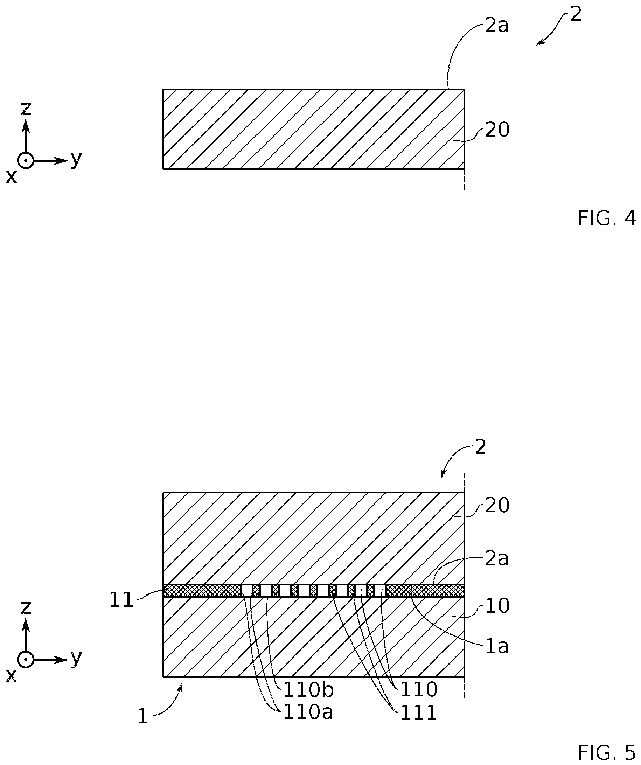

Comme illustré en figure 4, le procédé comprend la fourniture d'un substrat donneur 2. Le substrat donneur 2 peut comprendre une couche superficielle 20, par exemple faite ou à base de matériau semi-conducteur monocristallin. A titre d'exemple, le matériau semi-conducteur peut être choisi parmi le silicium, ou des alliages de silicium semiconducteurs tels que le carbure de silicium de formule SiC et un alliage de silicium-germanium de formule Si-Ge. Dans la suite, on se réfère au cas où le matériau semi-conducteur est fait de ou est à base de silicium. La couche superficielle 20 peut en outre être uniquement constituée de silicium monocristallin, en négligeant les impuretés liées à la l'élaboration du silicium.

Notons que sur les figures, seule la couche superficielle 20 du substrat donneur 2 est représentée. Comme pour le substrat support 1, le substrat donneur 2 peut néanmoins être sous la forme d'un empilement d'une pluralité de couches, par exemple faites ou à base de différents matériaux. La couche superficielle 20, est située en surface du substrat donneur 2 et présente une première surface 2a.

Le substrat donneur 2 peut par exemple être un substrat de type semi-conducteur-sur-isolant, et plus particulièrement de type silicium-sur-isolant (communément abrégé SOI, de l'anglais *Silicon-On-Insulator*), comprenant une couche d'oxyde enterrée (désignée communément par l'acronyme BOX, de l'anglais *Buried Oxide Layer*). Selon un exemple, le substrat donneur 2 est un substrat SOI de diamètre 200 mm. La couche BOX peut typiquement présenter une épaisseur de quelques centaines de nm et la couche superficielle 20 de silicium peut typiquement présenter une épaisseur comprise entre quelques centaines de nm à plusieurs µm. Si on cherche à obtenir une épaisseur particulièrement de la couche superficielle 20, la fourniture du substrat donneur 2 peut comprendre une oxydation d'une portion de la couche superficielle 20 depuis la surface 2a, pour former une portion oxydée (non représentée sur les figures) suivie d'une gravure de cette portion oxydée. Notons qu'on peut prévoir que la couche superficielle 20 soit recouverte d'une fine couche d'oxyde. Selon un exemple, le substrat donneur 2 est un wafer de silicium, par exemple de diamètre 200 mm.

Le procédé comprend ensuite un assemblage du substrat support 1 et du substrat donneur 2. Lors de cet assemblage, la première face 1a du substrat support 1 est jointe à la première face 2a du substrat donneur 2. La première face 1a du substrat support 1 et la première face 2a du substrat donneur 2 peuvent être directement en contact. Comme illustré en figure 5, le substrat donneur 2 recouvre au moins en partie, et de préférence totalement, les cavités élémentaires 110. Selon un exemple, le substrat support 1 et le substrat donneur 2 sont assemblés par collage direct, et plus particulièrement par adhésion moléculaires entre leurs premières faces 1a, 2a. Le collage direct peut être obtenu sans nécessiter l'application d'une pression importante sur les substrats à assembler. Une légère pression pourra simplement être appliquée pour initier le collage. Un recuit thermique peut en outre être effectué pour initier le collage.

Pour former la membrane 20' suspendue, le substrat donneur 2 est aminci, après l'assemblage. Le substrat donneur 2 peut plus particulièrement être aminci pour ne conserver que la portion destinée à former la membrane 20', d'une épaisseur comprise entre 0,05 µm et 20 µm, de préférence entre 0,1 µm et 2 µm.

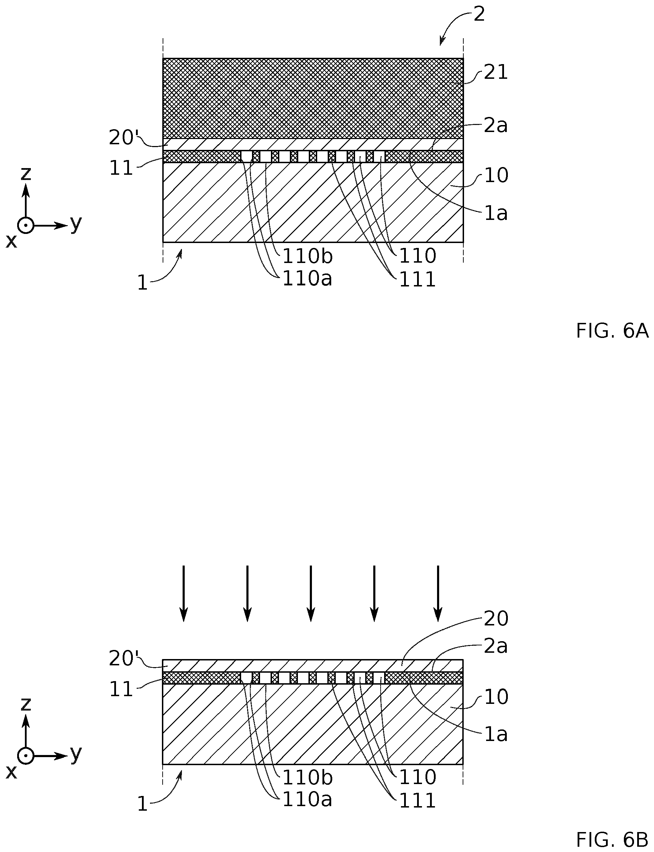

Selon un premier exemple, illustré par les figures 6A et 6B, l'amincissement du substrat donneur 2 peut comprendre une oxydation du substrat donneur 2 pour former une portion oxydée 21. La portion oxydée 21 peut s'étendre depuis une face arrière du substrat donneur 2, c'est-à-dire la face opposée à sa première face 2a, jusqu'à une première portion du substrat donneur 2 destinée à former la membrane 20'. La portion oxydée 21 peut ensuite être gravée, par exemple dans le sens des flèches illustrées en figure 6B. Comme l'illustre la figure 6B, on peut ne conserver que la première portion du substrat donneur 2 destinée à former la membrane 20'. Préalablement à l'oxydation du substrat donneur 2, le substrat donneur 2 peut en outre être aminci, par exemple par rectification mécanique de sa face arrière. Cet exemple de réalisation est particulièrement adapté pour former une membrane 20' d'une épaisseur comprise entre 2 µm et 20 µm.

Selon un exemple plus particulier, lorsque le substrat donneur 2 est un substrat de type semi-conducteur-sur-isolant, et plus particulièrement silicium-sur-isolant comprenant une couche d'oxyde enterrée, le substrat donneur peut être aminci, par exemple par rectification mécanique et/ou par polissage mécano-chimique et/ou par gravure chimique et/ou par gravure plasma, de sa face arrière jusqu'à la couche d'oxyde enterrée, et plus particulièrement jusqu'à la face supérieure de la couche d'oxyde enterrée. La couche d'oxyde enterrée peut ainsi former une barrière à la gravure. La couche d'oxyde enterrée peut ensuite être retirée, par exemple par gravure humide à l'acide fluorhydrique. Ainsi, on ne conserve que la première portion du substrat donneur 2 s'étendant initialement entre la surface 2a et la face inférieure de la couche d'oxyde enterrée, et destinée à former la membrane 20'. Cet exemple de réalisation est particulièrement adapté pour former une membrane 20' d'une épaisseur comprise entre 0,1 µm et 2 µm.

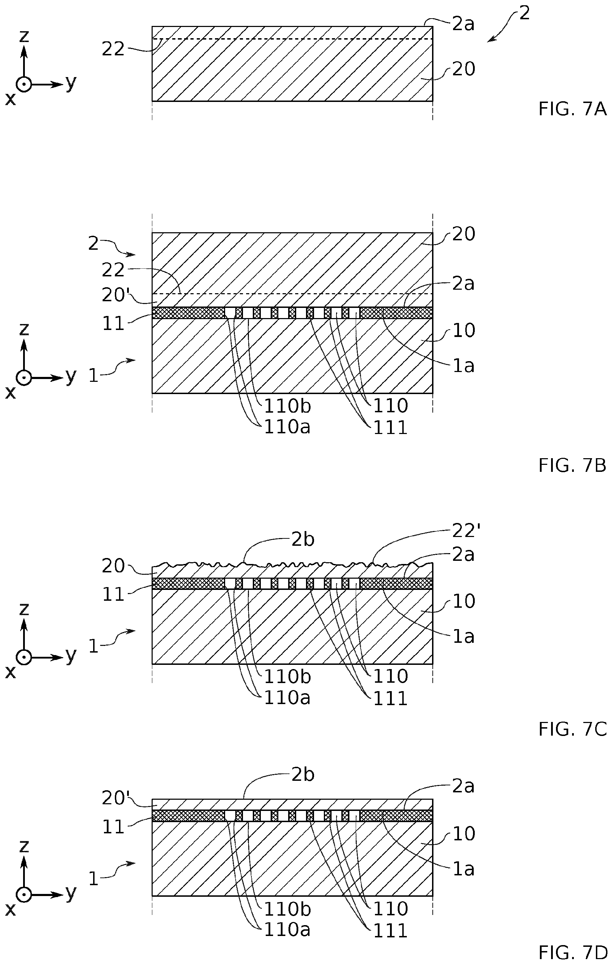

Selon un exemple alternatif, la fourniture du substrat donneur 2 peut comprendre une implantation d'espèces légères, par exemple d'ions, dans une portion enterrée 22 du substrat donneur 2. Comme illustré en figure 7B, la portion enterrée 22 peut être disposée à l'interface entre une première portion du substrat donneur 2 destinée à former la membrane 20' et une deuxième portion du substrat donneur 2, destinée à former le reste du substrat donneur 2, aussi appelé portion sacrificielle, et à être retiré par la suite. L'implantation peut être une implantation d'ions légers, par exemple d'ions hydrogène, à une profondeur d'implantation comprise entre quelques centaines de nm et quelques µm, par exemple entre 0,2 µm et 2 µm. Cet exemple de réalisation est particulièrement adapté pour former une membrane 20' d'une épaisseur comprise entre 0,1 µm et 2 µm.

Selon cet exemple, l'amincissement du substrat donneur 2 peut comprendre une fracture, ou de façon équivalente un détachement, du substrat donneur sur une zone de fracture 22' au niveau de la portion enterrée 22. Suite à cette fracture, la première portion du substrat donneur 2, destinée à former la membrane 20', peut rester en contact avec le substrat support 1, tandis que la deuxième portion du substrat donneur 2 peut être retirée, comme illustré en figure 7C. Cette fracture peut par exemple être réalisée mécaniquement et/ou par un recuit de fracture, effectué à une température de l'ordre de quelques centaines de degrés Celsius, par exemple de sensiblement 500 °C..

L'amincissement du substrat donneur 2, quel que soit l'exemple de réalisation mis en oeuvre, peut ensuite comprendre un polissage chimique, mécanique ou chimico-mécanique de la face arrière 2b du substrat donneur 2, comme l'illustre à titre d'exemple le passage de la figure 7C à la figure 7D. La membrane 20' obtenue suite à l'amincissement du substrat donneur 2 peut présenter une épaisseur comprise entre quelques centaines de nm à quelques µm, par exemple entre 0,2 µm et 2 µm.

Quelle que soit la méthode employée pour déposer une membrane 20' sur une ou des cavités élémentaires 110, lors du développement de l'invention il a été mis en évidence qu'il est difficile de garder la membrane 20' intègre au-delà d'une taille limite de cavités. Selon les deux premiers exemples décrits précédemment, cette taille limite est sensiblement de 200 µm. Selon le deuxième exemple, dans lequel l'amincissement du substrat donneur 2 est réalisé par implantation d'ions puis fracture du substrat donneur 2, cette taille limite est sensiblement de 50 µm.

Afin de dépasser cette taille limite, la formation de la membrane 20' est réalisée sur des cavités élémentaires 110. Les cavités élémentaires 110 sont ensuite élargies, selon au moins une direction, voire dans un plan, parallèle au plan principal d'extension (x, y) de la couche superficielle 11 du substrat support 1, pour former au moins une cavité finale 110'. Un ou des groupes de cavités élémentaires 110 peut être défini pour correspondre à une ou des cavités finales 110'. Comme détaillé ultérieurement, l'élargissement des cavités élémentaires 110 peut être effectué par gravure de la couche superficielle 11 du substrat support 1. Ainsi, les piliers 111 entre les cavités élémentaires 110 permettent d'étayer le substrat donneur 2, voire la membrane 20' lors de sa formation. Les cavités élémentaires 110 sur lesquelles la membrane 20' est suspendue sont ensuite élargies, voire fusionnées, pour former la cavité finale 110'. Le procédé permet ainsi de minimiser le risque d'endommager la membrane 20' du dispositif lors de sa fabrication. En outre, en élargissant les cavités élémentaires 110 postérieurement à la fabrication de la membrane 20', il est possible d'obtenir une membrane 20' suspendue au-dessus d'une ou de plusieurs cavités finales 110' plus larges que grâce aux solutions existantes.

Selon le type de dispositif visé, la géométrie de la cavité finale 110' peut varier. Le procédé permet de partir d'un substrat support 1 présentant des cavités élémentaires de dimensions latérales données, quelle que soit la géométrie visée de la cavité finale 110'. Suite à la fabrication de la membrane 20', les cavités élémentaires 110 peuvent être élargies à façon selon le type de dispositif visé. Le procédé de fabrication est ainsi versatile et simplifié par rapport aux solutions existantes.

Outre l'élargissement des cavités élémentaires 110 pour former la ou les cavités finales 110', le procédé comprend en outre une formation d'au moins un pilier d'ancrage 3 configuré pour supporter la membrane 20'. La gravure d'élargissement des cavités élémentaires 110 est en outre configurée de façon à graver sélectivement la couche superficielle 11 vis-à-vis du matériau du pilier d'ancrage 3. Pour cela, le pilier d'ancrage 3 peut être à base, voire fait, d'un matériau désigné ci-après « résistant à la gravure », c'est à dire présentant une résistance à la gravure supérieure à la résistance de la couche superficielle 11 à la gravure, lors de l'élargissement des cavités élémentaires 110. De préférence, dans les conditions de gravure de la couche superficielle 11 du substrat support 1, la vitesse de gravure du pilier d'ancrage 3 est inférieure à celle de la couche superficielle 11, voire négligeable.

De préférence, l'au moins un pilier d'ancrage 3 est disposé de façon à délimiter au moins en partie la cavité finale 110' à obtenir. Lors de la gravure de la couche superficielle 11 visant à élargir les cavités élémentaires 110, le pilier d'ancrage étant plus résistant à la gravure que la couche superficielle 11, il forme une limite physique à cette gravure. Lors de cette gravure, les piliers 111 étayant la membrane peuvent être retirés, d'où leur qualification de « temporaires ». La membrane 20' étant supportée par le pilier d'ancrage 3, son intégrité peut être assurée malgré le retrait des piliers 111 temporaires.

Le pilier d'ancrage 3 formant une limite physique à cette gravure, il permet selon sa disposition de pouvoir personnaliser la forme et les dimensions de la cavité finale 110' obtenue. En outre, il permet d'augmenter la reproductibilité du procédé, en limitant la gravure à la forme de la cavité finale 110' à obtenir.

La formation du pilier d'ancrage 3 est maintenant décrite en référence aux figures 8A à 9B. La formation du pilier d'ancrage 3 peut comprendre une gravure d'une portion de l'ensemble formé par le substrat support 1 et la membrane 20', comme l'illustre les flèches dans les figures 8A à 8C. La gravure peut être effectuée depuis la face arrière 20b' de la membrane jusqu'à un niveau du substrat support 1 correspondant au fond des cavités élémentaires 110. On peut prévoir que cette étape de gravure soit réalisée préalablement à l'amincissement du substrat donneur 2. Dès lors, cette étape de gravure peut être réalisée depuis la face arrière du substrat donneur 2, c'est à dire sa face opposée à sa première face 2a, jusqu'à un niveau du substrat support 1 correspondant au fond des cavités élémentaires 110.

Comme illustré sur la figure 8A, le substrat support 1 peut être gravé jusqu'à éliminer la couche superficielle 11. La portion gravée peut correspondre à l'emplacement du pilier d'ancrage 3 et donc délimiter la cavité finale 110' qui sera obtenue dans le plan (x, y). Cette étape de gravure peut en outre être utilisée pour délimiter dans le plan (x, y) la membrane 20', et lui donner la forme voulue. Un groupe de cavités élémentaire 110 défini pour correspondre à une cavité finale 110' peut comprendre toute cavité située à l'intérieur du pourtour 20d' de la membrane 20'. La portion non gravée du substrat donneur 1 et de la membrane 20' peut typiquement s'étendre latéralement jusqu'à 1 mm, de préférence jusqu'à plusieurs centaines de µm.

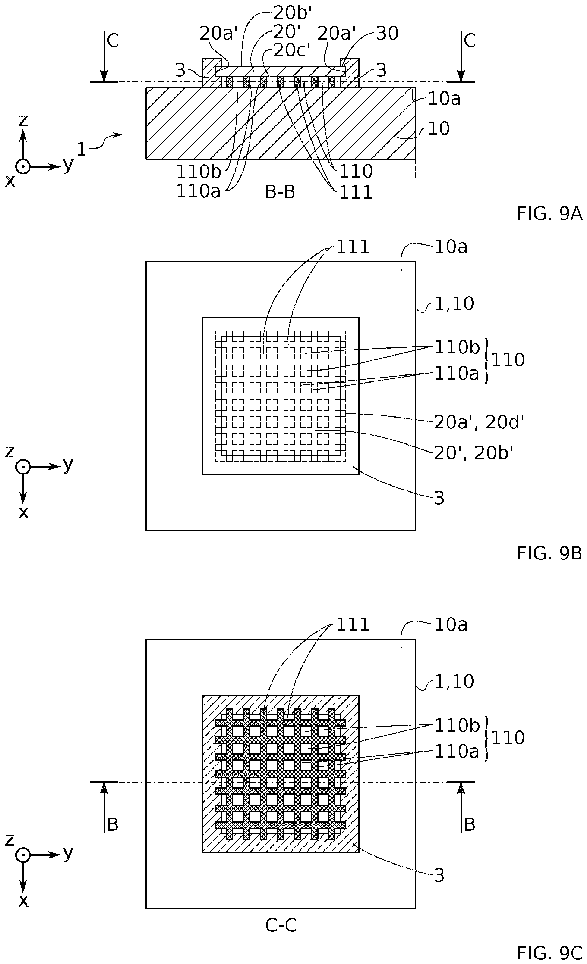

Le pilier d'ancrage 3 peut ensuite être formé par dépôt du matériau résistant à la gravure dans les portions gravées de l'ensemble formé par le substrat support 1 et la membrane 20'. Le pilier d'ancrage 3 peut s'étendre verticalement depuis la couche superficielle 11 du substrat support 1 jusqu'à la membrane 20', voire au-delà de la membrane 20'. De préférence, le dépôt de ce matériau est configuré de sorte que le pilier d'ancrage 3 suive le contour vertical de la bordure 20a' de la membrane 20'. Le pilier d'ancrage 3 obtenu supporte au moins la face inférieure 20c' de la membrane 20', au moins au niveau de sa bordure 20a', comme illustré en figure 9A. Ainsi le pilier d'ancrage 3 étaye la membrane 20' au moins à sa bordure 20a'. Selon un exemple, le pilier d'ancrage 3 comprend un profil en forme de mâchoire 30 disposé en regard de la membrane 20' et configuré pour enserrer la membrane 20' par sa face supérieure 20b' et sa face inférieure 20c', au niveau de sa bordure 20a'. Le profil en forme de mâchoire 30 peut plus particulièrement solidariser la membrane 20' au substrat support 1 dans tous ses degrés de liberté.

Comme illustré par les figures 8B, 8C et 9D, 9E, la formation du pilier d'ancrage 3 peut être configurée pour définir des membranes 20' adjacentes sur le substrat donneur 1, ces membranes 20' pouvant être supportées, au niveau d'une de leur bordure 20a' voisine entre elles, par un unique pilier d'ancrage 3.

Comme illustré par la figure 9B, la formation du pilier d'ancrage 3 peut être configurée de sorte que le pilier d'ancrage 3 est continu, et s'étend le long d'au moins une bordure de la membrane 20'. Selon un exemple, le pilier s'ancrage 3 est continu et s'étend le long d'au moins 80 %, voire 90 %, voire 99 %, voire 100 % de son pourtour 20d' de la membrane 20'. Ainsi, le pilier d'ancrage 3 assure un bon soutien mécanique à la membrane 20' le long de son pourtour 20d'. Le pilier d'ancrage 3 peut former un pourtour fermé de la membrane 20'.

Le dépôt du matériau résistant à la gravure peut être configuré de sorte que le pilier d'ancrage 3 suive le contour vertical de la membrane 20'. Le matériau peut infiltrer au moins en partie les cavités élémentaires 110 au niveau du pourtour 20d' de la membrane 20', comme illustré par la figure 9C.

Le pilier d'ancrage 3 formé peut s'étendre latéralement sur quelques µm jusqu'à la plus grande dimension de la cavité finale 110 visée, par exemple jusqu'à quelques mm. Le matériau résistant à la gravure peut être déposé par dépôt chimique en phase vapeur, et plus particulièrement par dépôt par couches atomiques (ALD). Le matériau résistant à la gravure peut être un semi-conducteur ou un diélectrique. Le matériau résistant à la gravure peut être le silicium monocristallin, le silicium poly-cristallin, le nitrure de silicium, l'alumine et un polymère, tel que le parylène. Dans le cas où le matériau résistant à la gravure est un polymère, le dépôt peut être réalisé par un dépôt chimique en phase vapeur communément désigné par le terme *Chemical Vapor Deposition* (abrégé CVD) en anglais. Le pilier d'ancrage 3 peut être formé de plusieurs matériaux, le pilier d'ancrage 3 peut par exemple être sous la forme d'un empilement d'une pluralité de couches faites ou à base de différents matériaux.

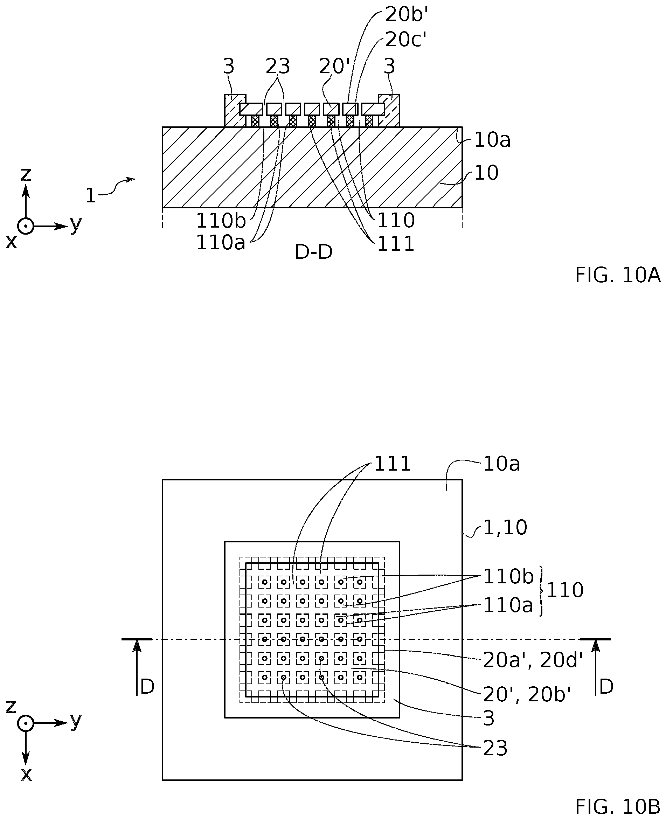

Afin de réaliser la gravure de la couche superficielle 11 du substrat support 1 de façon à élargir les cavités élémentaires 110, au moins une ouverture 23 est formée à travers la membrane 20'. Cette ouverture 23 peut ensuite être utilisée comme voie d'accès aux cavités élémentaires 110, pour injecter à travers cette ouverture 23 un composé de gravure de la couche superficielle 11. L'ouverture 23 est décrite en référence à la figure 10A. L'ouverture 23 peut s'étendre verticalement entre la face supérieure 20b' et la face inférieure 20c' de la membrane 20'. On peut prévoir que la formation de l'ouverture 23 soit réalisée préalablement à l'amincissement du substrat donneur 2. Dès lors, la formation de l'ouverture 23 peut être réalisée depuis la face arrière du substrat donneur 2 jusqu'à sa première face 2a.

L'ouverture 23 peut être formée à l'aplomb d'une cavité élémentaire 110. Ainsi, le composé de gravure peut être injecté dans une cavité élémentaire 110 pour graver les piliers 111 l'entourant. Une pluralité d'ouvertures 23 peut être formée dans la membrane 20', par exemple à l'aplomb de plusieurs cavités élémentaires 110, voire à l'aplomb de chaque cavité élémentaire 110 comme illustré en figure 10B. En alternative ou en complément, une ou des ouvertures 23 peuvent être formées à l'aplomb d'un pilier 111. En projection dans un plan parallèle au plan principal d'extension (x, y) de la couche superficielle 11 du substrat support 1, la surface d'une ouverture 23, voire de chaque ouverture 23, peut être contenue dans la surface d'une cavité élémentaire 110. Selon un exemple, la ou les ouvertures 23 sont de forme circulaire et présentent un diamètre de l'ordre de quelques µm, par exemple compris entre 1 µm et 10 µm.

Un composé de gravure des piliers 111 peut ensuite être injecté à travers la ou les ouvertures 23 formées pour éliminer les piliers 111. La gravure de la couche superficielle 11 est de préférence une gravure humide. Une gravure humide est avantageusement plus simple à mettre en oeuvre et réduit le coût du procédé. Ce composé de gravure peut être de l'acide fluorhydrique sous forme de vapeur ou à l'état liquide, voire de l'acide fluorhydrique en solution. Ainsi, lorsque la couche superficielle 11 à base de ou est faite d'un oxyde, l'oxyde constituant les piliers 111 peut être éliminé. Lors de l'injection du composé de gravure à travers l'ouverture 23, les piliers sont éliminés de proche en proche à partir du point d'injection. Selon le temps de gravure et la quantité de composé de gravure utilisée, une partie des piliers 111 peut être éliminée sur l'étendue de la cavité finale 110' dans le plan (x, y). Des piliers 111 peuvent donc subsister à l'issue de la gravure, par exemple au centre de la membrane dans le plan (x, y). Les piliers 111 subsistants peuvent délimiter plusieurs cavités finales 110' sous la membrane 20'. Selon un exemple la totalité des piliers 111 peut être éliminée sur l'étendue de la cavité finale 110' dans le plan (x, y), comme illustré par les figures 11A, 11B et 11C.

Lors de la gravure des piliers 111 par injection d'un composé de gravure, des chemins préférentiels peuvent apparaître, par exemple selon une direction préférentielle dans le plan (x, y). Le pilier d'ancrage 3 étant formé d'un matériau résistant à cette gravure, et plus particulièrement au composé de gravure, la gravure peut être réalisée de façon à éliminer les piliers 111 jusqu'à atteindre le pilier d'ancrage 3. Ainsi, il est possible de s'affranchir d'une éventuelle apparition de chemins préférentiels de gravure pour obtenir une cavité finale 110' de forme définie et reproductible. Par exemple, le temps de gravure peut être choisi de façon à permettre l'élimination totale des piliers 111 sur l'étendue de la cavité finale 110'.

Les ouvertures 23 peuvent ensuite être rebouchées si nécessaire, par exemple pour finaliser le dispositif 4.

Le procédé peut en outre comprendre une rectification mécanique et/ou au moins un polissage mécano-chimique et/ou au moins une gravure chimique au niveau de la face arrière 1b du substrat support 1, illustrée par exemple en figure 11A, afin de moduler l'épaisseur du substrat support 1.

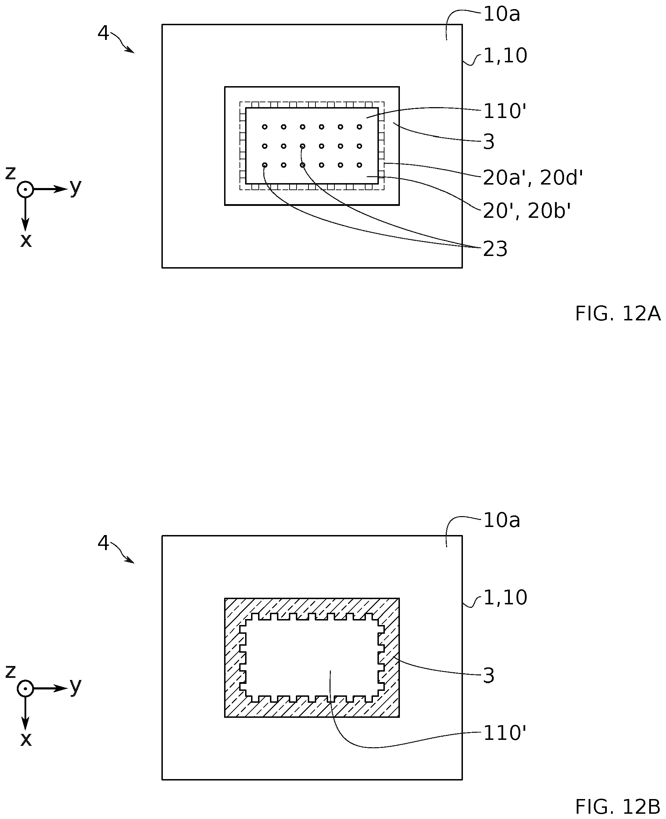

On obtient un dispositif 4 comprenant une membrane 110' suspendue au-dessus d'au moins une cavité finale 110'. On comprend que selon la géométrie des cavités élémentaires 110, leur répartition en surface du substrat support 1, les dimensions de la membrane 20' et la disposition du ou des piliers d'ancrage 3, une pluralité de dispositif 4 peuvent être obtenus. Des cavités finales 110' de toute géométrie peuvent être obtenues de façon reproductible. Des cavités finales 110' présentant de grandes dimensions, par exemple supérieure à 200 x 200 µm, peuvent être obtenues. Il est possible d'obtenir des cavités finales 110' d'une forme présentant des dimensions sensiblement égales entre elles dans le plan (x, y), par exemple ronde, ou carrée comme illustré par les figures 11B et 11C. En alternative, il est possible d'obtenir des cavités finales 110' d'une forme présentant des dimensions différentes entre elles dans le plan (x, y), par exemple un rectangle comme illustré par les figure 12A et 12B, ou encore en forme de « L ».

Des variantes du procédé de fabrication d'un dispositif microélectronique 4 comprenant une membrane 20' suspendue au-dessus d'au moins une cavité finale 110' sont maintenant décrites à titre d'exemple.

Le procédé peut être configuré de sorte que la membrane 20' présente toute forme géométrique dans le plan (x, y). Par exemple, la membrane 20' peut être sous la forme d'un anneau, c'est-à-dire d'un disque s'étendant dans le plan (x, y) et comprenant une ouverture centrale. L'étape de gravure de la membrane 20', préalablement au dépôt du ou des matériaux du pilier d'ancrage 3 peut par exemple servir à donner sa forme géométrique dans le plan (x, y) à la membrane 20'.

Le pilier d'ancrage 3 peut être discontinu, ou de façon équivalente une pluralité de piliers d'ancrage 3 ponctuels peut être formée. Les piliers d'ancrage 3 peuvent être repartis le long d'au moins une bordure 20a' de la membrane 20', voire le long de son pourtour 20d'. Les piliers d'ancrage 3 peuvent former un pourtour discontinu de la membrane 20d', afin d'assurer un bon soutien mécanique à la membrane 20' le long de son pourtour 20d'.

La formation du ou des piliers d'ancrage 3 peut être réalisée avant l'assemblage du substrat support 1 et du substrat donneur 2. Par exemple, les piliers d'ancrage 3 peuvent être formés avant ou concomitamment à la formation des cavités élémentaires 110. Le pilier d'ancrage 3 peut être déposé dans une cavité élémentaire 110 déjà formée. Suite à l'assemblage du substrat support 1 et du substrat donneur 2, et à la formation de la membrane 20', au moins un pilier d'ancrage 3 peut ainsi être éloigné du pourtour 20d' de la membrane 20'. Par exemple, ce pilier d'ancrage 3 peut être situé au centre de la membrane 20'. Le pilier d'ancrage 3 peut ainsi délimiter au moins deux cavités finales 110' sous une membrane 20', ou de façon équivalente délimiter deux membranes 20', une pour chaque cavité finale 110', les deux membranes étant en continu l'une de l'autre.

Au vu de la description qui précède, il apparaît clairement que l'invention propose un procédé de fabrication d'un dispositif comprenant une membrane suspendue au-dessus d'au moins une cavité finale, amélioré par rapport aux solutions existantes. Notamment, le procédé de fabrication permet de moduler les dimensions de la cavité finale tout en préservant l'intégrité de la membrane.

L'invention n'est pas limitée aux modes de réalisations précédemment décrits et s'étend à tous les modes de réalisation couverts par les revendications.

### REFERENCES

1 Substrat support
1a Première face
10 Portion supérieure
10a Interface avec la couche superficielle
11 Couche superficielle
110 Cavité élémentaire
110' Cavité finale
110a Paroi latérale
110b Fond
111 Pilier
2 Substrat donneur
2a Première face
20 Couche superficielle
20' Membrane
20a' Bordure
20b' Face supérieure
20c' Face inférieure
20d' Pourtour
21 Portion oxydée
2b Face arrière
22 Portion enterrée
22' Zone de fracture
23 Ouverture
3 Pilier d'ancrage
30 Profil en forme de mâchoire

## Revendications

1. Procédé de fabrication d'un dispositif (4) microélectronique comprenant une membrane (20') suspendue au-dessus d'au moins une cavité finale (110'), le procédé comprenant :
• une fourniture d'un substrat support (1) comprenant une couche superficielle (11) présentant une première face (1a),
• une formation d'au moins une cavité élémentaire (110) dans la couche superficielle (11) du substrat support (1), l'au moins une cavité élémentaire (110) débouchant au niveau de ladite première face (1a), et
• une fourniture d'un substrat donneur (2) présentant une première face (2a), puis
• une formation d'au moins une membrane (20') suspendue au-dessus d'au moins une cavité finale (110'), la formation de la membrane (20') comprenant :
∘ un assemblage du substrat support (1) et du substrat donneur (2) en adjoignant la première face (1a) du substrat support (1) à la première face (2a) du substrat donneur (2), de sorte que le substrat donneur (2) recouvre au moins en partie l'au moins une cavité élémentaire (110), puis
∘ un amincissement du substrat donneur (2) de façon à former la membrane (20'),
**caractérisé en ce que** le procédé comprend en outre :
• avant ou après la formation de la membrane (20'), une formation d'au moins un pilier d'ancrage (3) de la membrane (20'), l'au moins un pilier d'ancrage (3) étant :
∘ à base d'au moins un matériau différent d'un matériau formant la couche superficielle (11), et
∘ configuré pour supporter au moins une face inférieure (20c') de la membrane (20'), au moins au niveau d'une bordure (20a') de la membrane (20'), et
• après la formation de l'au moins un pilier d'ancrage (3), et après l'assemblage, une gravure de la couche superficielle (11) du substrat support (1) de façon à élargir l'au moins une cavité élémentaire (110), selon au moins une direction parallèle à un plan principal d'extension (x, y) de la première face (1a) de la couche superficielle (11) du substrat support (1), pour former la cavité finale (110'), ladite gravure étant configurée de façon à graver sélectivement la couche superficielle (11) vis-à-vis de l'eau moins un matériau de l'au moins un pilier d'ancrage (3).

2. Procédé selon la revendication précédente, dans lequel la formation de l'au moins un pilier d'ancrage (3) est configurée de sorte que l'au moins un pilier d'ancrage (3) est continu, et s'étend le long d'au moins une bordure (20a') de la membrane (20').

3. Procédé selon la revendication 1, dans lequel la formation de l'au moins un pilier d'ancrage (3) est configurée de sorte que l'au moins un pilier d'ancrage (3) est ponctuel, une pluralité de piliers d'ancrage (3) étant repartis le long d'au moins une bordure (20a') de la membrane (20').

4. Procédé selon l'une quelconque des revendications précédentes, dans lequel la formation de l'au moins un pilier d'ancrage (3) est configurée de sorte que l'au moins un pilier d'ancrage (3) est configuré pour enserrer au moins la face inférieure (20c') et une face supérieure (20b') de la membrane (20').

5. Procédé selon l'une quelconque des revendications précédentes, dans lequel, l'au moins une cavité élémentaire (110) étant définie par des parois latérales (110a) et un fond (110b), la formation de l'au moins un pilier d'ancrage (3) est effectuée après l'assemblage du substrat support (1) et du substrat donneur (2) et comprend :
• une gravure d'au moins une portion de l'assemblage formé par le substrat donneur (2) et le substrat support (1), depuis l'un parmi une deuxième face (2b) du substrat donneur (2) ou une face supérieure (20b') de la membrane (20'), jusqu'à une profondeur du substrat support (1) égale à une profondeur du fond (110b) de l'au moins une cavité élémentaire (110),
• un dépôt de l'au moins un matériau de l'au moins un pilier d'ancrage.

6. Procédé selon la revendication précédente, dans lequel le dépôt de l'au moins un matériau de l'au moins un pilier d'ancrage est un dépôt par couches atomiques.

7. Procédé selon l'une quelconque des revendications précédentes, dans lequel la gravure de la couche superficielle (11) du substrat support (1) comprend :
• une formation d'au moins une ouverture (23) à travers l'un parmi le substrat donneur (2) et la membrane (20'),
• une injection par l'au moins une ouverture (23), d'un composé de gravure.

8. Procédé selon l'une quelconque des revendications précédentes, dans lequel, lors de la formation de l'au moins une cavité élémentaire (110) dans la couche superficielle (11) du substrat support (1), plusieurs cavités élémentaires (110) sont formées, les cavités élémentaires (110) formant un réseau, de préférence périodique dans le plan principal d'extension (x, y) de la première face (1a) de la couche superficielle (11) du substrat support (1).

9. Procédé selon l'une quelconque des revendications précédentes, dans lequel :
• lors de la formation de l'au moins une cavité élémentaire (110) dans la couche superficielle (11) du substrat support (1), plusieurs cavités élémentaires (110) sont formées,
• le procédé comprend, préalablement à la gravure de la couche superficielle (11) du substrat support (1), une étape de définition d'un groupe de cavités élémentaires (110), et
• la gravure de la couche superficielle (11) du substrat support (1) est configurée pour fusionner ensemble les cavités élémentaires (110) dudit groupe, pour former la cavité finale (110').

10. Procédé selon l'une quelconque des revendications précédentes, dans lequel l'amincissement du substrat donneur (2) comprend une oxydation du substrat donneur (2), pour former une portion oxydée (21) s'étendant jusqu'à une première portion du substrat donneur (2) destinée à former la membrane (20'), puis une gravure de la portion oxydée (21) du substrat donneur (2).

11. Procédé selon l'une quelconque des revendications 1 à 9, dans lequel :
• la fourniture du substrat donneur (2) comprend une implantation d'ions dans une portion enterrée (22) du substrat donneur (2), la portion enterrée (22) étant disposée à l'interface entre une première portion du substrat donneur destinée à former la membrane (20') et une deuxième portion du substrat donneur (2) destinée à former le reste du substrat donneur (2), et
• l'amincissement du substrat donneur (2) comprend une fracture du substrat donneur (2) au niveau de la portion enterrée (22).

12. Procédé selon l'une quelconque des revendications précédentes, dans lequel l'assemblage du substrat support (1) et du substrat donneur (2) comprend le collage direct de la première face (1a) du substrat donneur (1) à la première face (2a) du substrat support (2).

13. Procédé selon l'une quelconque des revendications précédentes, dans lequel l'amincissement du substrat donneur (2) est configuré de façon à obtenir une membrane (20') d'épaisseur comprise entre 0,05 µm et 20 µm.

14. Procédé selon l'une quelconque des revendications précédentes, dans lequel l'au moins un pilier d'ancrage (3) est fait ou est à base d'au moins un parmi le silicium monocristallin, le silicium polycristallin, le nitrure de silicium, l'alumine et un polymère.

15. Procédé selon l'une quelconque des revendications précédentes, dans lequel au moins l'une parmi une portion supérieure (10) du substrat support (1) et une couche superficielle (20) du substrat donneur (2) est faite ou est à base d'au moins un parmi le silicium, un alliage semi-conducteur de silicium tels que le carbure de silicium et un alliage de silicium-germanium.

## Patentansprüche

1. Verfahren zum Herstellen einer mikroelektronischen Vorrichtung (4), die eine Membran (20') umfasst, die über mindestens einem Endhohlraum (110') aufgehängt ist, wobei das Verfahren Folgendes umfasst:
• Bereitstellen eines Trägersubstrats (1), das eine Oberflächenschicht (11) mit einer ersten Seite (1a) umfasst,
• Bilden mindestens eines Elementarhohlraums (110) in der Oberflächenschicht (11) des Trägersubstrats (1), wobei sich der mindestens eine Elementarhohlraum (110) auf der Höhe der ersten Seite (1a) öffnet, und
• Bilden eines Donorsubstrats (2) mit einer ersten Seite (2a), dann
• Bilden mindestens einer Membran (20'), die über mindestens einem Endhohlraum (110') aufgehängt ist, wobei das Bilden der Membran (20') Folgendes umfasst:
∘ Zusammenfügen des Trägersubstrats (1) und des Donorsubstrats (2) durch Hinzufügen der ersten Seite (1a) des Trägersubstrats (1) zu der ersten Seite (2a) des Donorsubstrats (2), so dass das Donorsubstrat (2) den mindestens einen Elementarhohlraum (110) mindestens teilweise bedeckt, dann
∘ Ausdünnen des Donorsubstrats (2), um die Membran (20') zu bilden,
**dadurch gekennzeichnet, dass** das Verfahren ferner Folgendes umfasst:
• vor oder nach dem Bilden der Membran (20'), Bilden mindestens eines Verankerungspfeilers (3) der Membran (20'), wobei der mindestens eine Verankerungspfeiler (3):
∘ auf mindestens einem Material basiert, das sich von einem Material unterscheidet, das die Oberflächenschicht (11) bildet, und
∘ so konfiguriert ist, dass er mindestens eine untere Seite (20c') der Membran (20') mindestens auf der Höhe einer Kante (20a') der Membran (20') stützt, und
• nach dem Bilden des mindestens einen Verankerungspfeilers (3) und danach dem Zusammenfügen, ein derartiges Ätzen der Oberflächenschicht (11) des Trägersubstrats (1), dass der mindestens eine Elementarhohlraum (110) gemäß mindestens einer Richtung parallel zu einer Haupterstreckungsebene (x, y) der ersten Seite (1a) der Oberflächenschicht (11) des Trägersubstrats (1), um den Endhohlraum (110') zu bilden, wobei das Ätzen derart konfiguriert ist, dass die Oberflächenschicht (11) selektiv gegenüber dem mindestens einen Material des mindestens einen Verankerungspfeilers (3) geätzt wird.

2. Verfahren nach dem vorhergehenden Anspruch, wobei das Bilden des mindestens einen Verankerungspfeilers (3) derart konfiguriert ist, dass der mindestens eine Verankerungspfeiler (3) durchgehend ist und sich mindestens entlang einer Kante (20a') der Membran (20') erstreckt.

3. Verfahren nach Anspruch 1, wobei das Bilden des mindestens einen Verankerungspfeilers (3) derart konfiguriert ist, dass der mindestens eine Verankerungspfeiler (3) punktförmig ist, wobei entlang mindestens einer Kante (20a') der Membran (20') eine Vielzahl von Verankerungspfeilern (3) verteilt sind.

4. Verfahren nach einem der vorhergehenden Ansprüche, bei dem das Bilden des mindestens einen Verankerungspfeilers (3) derart konfiguriert ist, dass der mindestens eine Verankerungspfeiler (3) konfiguriert ist, um mindestens die untere Seite (20c') und eine obere Seite (20b') der Membran (20') zu umschließen.

5. Verfahren nach einem der vorhergehenden Ansprüche, bei dem der mindestens eine Elementarhohlraum (110) durch Seitenwände (110a) und einen Boden (110b) definiert wird, wobei das Bilden des mindestens einen Verankerungspfeilers (3) nach dem Zusammenfügen des Trägersubstrats (1) und des Donorsubstrats (2) erfolgt und Folgendes umfasst:
• ein Ätzen mindestens eines Abschnitts der Anordnung, die durch das Donorsubstrat (2) und das Trägersubstrat (1) gebildet wird, entweder von einer zweiten Seite (2b) des Donorsubstrats (2) oder einer oberen Seite (20b') der Membran (20') bis zu einer Tiefe des Trägersubstrats (1), die gleich einer Tiefe des Bodens (110b) des mindestens einen Elementarhohlraums (110) ist,
• ein Abscheiden des mindestens einen Materials von dem mindestens einen Verankerungspfeiler.

6. Verfahren nach dem vorhergehenden Anspruch, bei dem das Abscheiden des mindestens einen Materials des mindestens einen Verankerungspfeilers ein Abscheiden durch Atomlagen ist.

7. Verfahren nach einem der vorhergehenden Ansprüche, bei dem das Ätzen der Oberflächenschicht (11) des Trägersubstrats (1) Folgendes umfasst:
• Bilden mindestens einer Öffnung (23) durch entweder das Donorsubstrat (2) oder die Membran (20'),
• Einspritzen einer Ätzverbindung durch die mindestens eine Öffnung (23).

8. Verfahren nach einem der vorhergehenden Ansprüche, bei dem das Bilden des mindestens einen Elementarhohlraums (110) in der Oberflächenschicht (11) des Trägersubstrats (1) mehrere Elementarhohlräume (110) gebildet werden, wobei die Elementarhohlräume (110) ein Netzwerk bilden, vorzugsweise periodisch in der Haupterstreckungsebene (x, y) der ersten Seite (1a) der Oberflächenschicht (11) des Trägersubstrats (1).

9. Verfahren nach einem der vorhergehenden Ansprüche, bei dem:
• beim Bilden des mindestens einen Elementarhohlraums (110) in der Oberflächenschicht (11) des Trägersubstrats (1) mehrere Elementarhohlräume (110) gebildet werden,
• das Verfahren vor dem Ätzen der Oberflächenschicht (11) des Trägersubstrats (1) einen Schritt zum Definieren einer Gruppe von Elementarhohlräumen (110) umfasst, und
• das Ätzen der Oberflächenschicht (11) des Trägersubstrats (1) konfiguriert ist, um die Elementarhohlräume (110) der Gruppe zusammenzuführen, um den Endhohlraum (110') zu bilden.

10. Verfahren nach einem der vorhergehenden Ansprüche, bei dem das Ausdünnen des Donorsubstrats (2) eine Oxidation des Donorsubstrats (2) umfasst, um einen oxidierten Abschnitt (21) zu bilden, der sich zu einem ersten Abschnitt des Donorsubstrats (2) erstreckt, der dazu bestimmt ist, die Membran (20') zu bilden, dann Ätzen des oxidierten Abschnitts (21) des Donorsubstrats (2).

11. Verfahren nach einem der Ansprüche 1 bis 9, bei dem:
• das Bereitstellen des Donorsubstrats (2) eine lonenimplantation in einen vergrabenen Abschnitt (22) des Donorsubstrats (2) umfasst, wobei der vergrabene Abschnitt (22) an der Grenzfläche zwischen einem ersten Abschnitt des Donorsubstrats, der dazu bestimmt ist, die Membran (20') zu bilden, und einem zweiten Abschnitt des Donorsubstrats (2) angeordnet ist, der dazu bestimmt ist, den Rest des Donorsubstrats (2) zu bilden, und
• das Ausdünnen des Donorsubstrats (2) einen Bruch des Donorsubstrats (2) auf Höhe des vergrabenen Abschnitts (22) umfasst.

12. Verfahren nach einem der vorhergehenden Ansprüche, bei dem das Zusammenfügen des Trägersubstrats (1) und des Donorsubstrats (2) das direkte Verkleben der ersten Seite (1a) des Donorsubstrats (1) mit der ersten Seite (2a) des Trägersubstrats (2) umfasst.

13. Verfahren nach einem der vorhergehenden Ansprüche, bei dem das Ausdünnen des Donorsubstrats (2) derart konfiguriert ist, dass eine Membran (20') mit einer Dicke zwischen 0,05 µm und 20 µm erhalten wird.

14. Verfahren nach einem der vorhergehenden Ansprüche, bei dem der mindestens eine Verankerungspfeiler (3) aus mindestens einem von monokristallinem Silizium, polykristallinem Silizium, Siliziumnitrid, Aluminiumoxid und einem Polymer hergestellt ist oder darauf basiert.

15. Verfahren nach einem der vorhergehenden Ansprüche, bei dem mindestens eines aus einem oberen Abschnitt (10) des Trägersubstrats (1) und einer Oberflächenschicht (20) des Donorsubstrats (2) aus mindestens einem von Silizium, einer Halbleiterlegierung aus Silizium, wie etwa Siliziumcarbid, und einer Silizium-Germanium-Legierung hergestellt wird oder darauf basiert.

## Claims

1. A method for manufacturing a microelectronic device (4) comprising a membrane (20') suspended over at least one final cavity (110'), the method comprising:
• providing a support substrate (1) comprising a superficial layer (11) having a first face (1a),
• forming at least one elementary cavity (110) in the superficial layer (11) of the support substrate (1), the at least one elementary cavity (110) opening at said first face (1a), and
• providing a donor substrate (2) having a first face (2a), then
• forming at least one membrane (20') suspended over at least one final cavity (110'), forming the membrane (20') comprising:
∘ assembling the support substrate (1) and the donor substrate (2) by joining the first face (1a) of the support substrate (1) to the first face (2a) of the donor substrate (2), so that the donor substrate (2) covers at least partially the at least one elementary cavity (110), then
∘ thinning the donor substrate (2) so as to form the membrane (20'),
**characterised in that** the method further comprises:
• before or after forming the membrane (20'), forming at least one anchoring pillar (3) of the membrane (20'), the at least one anchoring pillar (3) being:
∘ based on at least one material different from a material forming the superficial layer (11), and
∘ configured to support at least one lower face (20c') of the membrane (20'), at least at an edge (20a') of the membrane (20'), and
• after forming the at least one anchoring pillar (3), and after assembly, etching the superficial layer (11) of the support substrate (1) so as to enlarge the at least one elementary cavity (110), according to at least one direction parallel to a main plane of extension (x, y) of the first face (1a) of the superficial layer (11) of the support substrate (1), to form the final cavity (110'), said etching being configured so as to selectively etch the superficial layer (11) with respect to the at least one material of the at least one anchoring pillar (3).

2. The method according to the preceding claim, wherein forming the at least one anchoring pillar (3) is configured so that the at least one anchoring pillar (3) is continuous, and extends along at least one edge (20a') of the membrane (20').

3. The method of claim 1, wherein forming the at least one anchoring pillar (3) is configured so that the at least one anchoring pillar (3) is punctual, a plurality of anchoring pillars (3) being distributed along at least one edge (20a') of the membrane (20').

4. The method according to any one of the preceding claims, wherein forming the at least one anchoring pillar (3) is configured so that the at least one anchoring pillar (3) is configured to clasp at least the lower face (20c') and an upper face (20b') of the membrane (20').

5. The method according to any one of the preceding claims, wherein the at least one elementary cavity (110) being defined by lateral walls (110a) and a bottom (110b), forming the at least one anchoring pillar (3) is performed after assembly of the support substrate (1) and the donor substrate (2) and comprises:
• etching at least one portion of the assembly formed by the donor substrate (2) and the support substrate (1), starting from one amongst a second face (2b) of the donor substrate (2) or an upper face (20b') of the membrane (20'), up to a depth of the support substrate (1) equal to a depth of the bottom (110b) of the at last one elementary cavity (110);
• depositing the at least one material of the at least one anchoring pillar.

6. The method according to the preceding claim, wherein the deposition of the at least one material of the at least one anchoring pillar is an atomic layer deposition.

7. The method according to any one of the preceding claims, wherein etching the superficial layer (11) of the support substrate (1) comprises:
• forming at least one opening (23) through one amongst the donor substrate (2) and the membrane (20'),
• injecting an etching compound through the at least one opening (23).

8. The method according to any one of the preceding claims, wherein when forming the at least one elementary cavity (110) in the superficial layer (11) of the support substrate (1), several elementary cavities (110) are formed, the elementary cavities (110) forming an array, preferably periodic, in the main plane of extension (x, y) of the first face (1a) of the superficial layer (11) of the support substrate (1).

9. The method according to any one of the preceding claims, wherein:
• when forming the at least one elementary cavity (110) in the superficial layer (11) of the support substrate (1), several elementary cavities (110) are formed,
• the method comprises, prior to etching of the superficial layer (11) of the support substrate (1), a step of defining a group of elementary cavities (110), and
• etching the superficial layer (11) of the support substrate (1) is configured to merge the elementary cavities (110) of said group together, to form the final cavity (110').

10. The method according to any one of the preceding claims, wherein thinning the donor substrate (2) comprises oxidising the donor substrate (2), to form an oxidised portion (21) extending up to a first portion of the donor substrate (2) intended to form the membrane (20'), then etching the oxidised portion (21) of the donor substrate (2).

11. The method according to any one of claims 1 to 9, wherein:
• providing the donor substrate (2) comprises implanting ions in a buried portion (22) of the donor substrate (2), the buried portion (22) being disposed at the interface between a first portion of the donor substrate intended to form the membrane (20') and a second portion of the donor substrate (2) intended to form the rest of the donor substrate (2), and
• thinning the donor substrate (2) comprises fracturing the donor substrate (2) at the buried portion (22).

12. The method according to any one of the preceding claims, wherein assembling the support substrate (1) and the donor substrate (2) comprises direct bonding of the first face (1a) of the donor substrate (1) to the first face (2a) of the support substrate (2).

13. The method according to any one of the preceding claims, wherein thinning the donor substrate (2) is configured so as to obtain a membrane (20') with a thickness comprised between 0.05 µm and 20 µm.

14. The method according to any one of the preceding claims, wherein the at least one anchoring pillar (3) is made of or is based on at least one amongst monocrystalline silicon, polycrystalline silicon, silicon nitride, alumina and a polymer.

15. The method according to any one of the preceding claims, wherein at least one amongst an upper portion (10) of the support substrate (1) and a superficial layer (20) of the donor substrate (2) is made of or is based on at least one amongst silicon, a silicon semiconductor alloy such as silicon carbide and a silicon-germanium alloy.
